# EUROPEAN PATENT APPLICATION

(11) **EP 0 978 940 A1**
(43) Date of publication of application: **09.02.2000**
(21) Application number: 99115035.0
(22) Date of filing: 03.08.1999
(51) Int. Cl.: H03J 1/00, H04N 7/081

(54) **Broadcast receiver system**

(30) Priority: 06.08.1998 JP 22337298
(71) Applicant: Pioneer Corporation, Meguro-ku, Tokyo (JP)
(72) Inventor: Uchiyama, Kazuhiko, Pioneer Corporation Kawagoe W., Kawagoe-shi, Saitama (JP)
(74) Representative: Klingseisen, Franz, Dipl.-Ing.

(57) **Abstract**

A broadcast receiver system is disclosed which makes use of the network follow function for television broadcast in a simple manner. The broadcast receiver system having a tuner (100) for receiving television broadcast stations of selected tuning frequencies comprises storing means (70) for storing, for each television broadcast network, transmission frequencies of television broadcast stations transmitted from transmission stations of the same network, and pieces of location information relating to the transmission stations by associating the pieces of location information with the transmission frequencies; location acquiring means (N1) for acquiring location information relating to location of the broadcast receiver system; electromagnetic field intensity detection means (400) for generating initiating commands to initiate a network follow in accordance with the quality of the received television broadcast waves; and control means (60') responsive to the initiating commands for selecting, from the stored contents in the storing means (70), a transmission frequency of receivable television broadcast that belongs to a broadcast network of a broadcast being currently received and is different from the frequency of the broadcast station currently being received in accordance with the location information acquired by the location acquiring means (N1), and for setting the selected transmission frequency to the tuner.

## Description

### BACKGROUND OF THE INVENTION

### 1. Field of the Invention

The present invention relates to broadcast receiver systems and, more particularly, to a broadcast receiver system for receiving television broadcast waves.

### 2. Description of the Related Art

The RDS system (Radio Data System) performs transmission and reception of broadcast waves into which FM audio signals, and data signals relating to the broadcast stations that transmits the FM audio signals or relating to the broadcast are multiplexed, thus providing various functions and conveniences for receivers and users. Among technical documents relating to the RDS are: Japanese Laid-Open Patent Publication No. H7-58598 (1995), Japanese Laid-Open Patent Publication No. H8-79018 (1996), and Japanese Laid-Open Patent Publication No. H8-79016 (1996).

As seen in such prior art, one of the major functions of the RDS receiver is a function called "network follow". A typical network follow is reception control for maintaining constant a program of the broadcast wave currently being received by a receiver even though the reception environment has varied. More specifically, in the case where the reception environment has adversely changed, it selects and receives another broadcast wave that provides the same program of the broadcast wave currently being received and is considered to provide better reception quality, in accordance with the data signal multiplexed into broadcast waves.

In the foregoing, a broadcast station transmitting a broadcast wave currently being received and another broadcast station transmitting another broadcast wave, both of which provide the same program, ordinarily belong to the same broadcast network station. Thus, reception control for following the same program is called the "network follow". In the case of RDS, the network follow is realized by means of a piece of information called PI (Program Identification) code, included in the data signal, which allows identifying networks and programs, or together with the information, by means of frequency information, included in the data signal, relating to the broadcast wave transmitted from another station which belongs to the same network.

However, such network follow is applied only to the broadcast waves of audio programs that provide programs broadcast only by audio. That is, it does not provide the same network follow for broadcast waves of ordinary television programs that provide programs by image.

Like the RDS, the network follow of television programs is feasible from a technical viewpoint for television broadcast waves. This can be done by transmitting additional data signals that allow for identifying networks and by using the added data signals at reception sides. However, implementing this transmission scheme would lead to a drastic change in the whole broadcasting system and result in a great amount of cost.

### SUMMARY OF THE INVENTION

The present invention was developed in view of the foregoing points. It is an object of the present invention to provide a broadcast receiver system that makes use of the network follow function for television broadcast waves in a simple manner.

A broadcast receiver according to an embodiment of the present invention is a broadcast receiver having a tuner for receiving television broadcast waves of selected tuning frequencies, comprising: storing means for storing, for each television broadcast network, transmission frequencies of television broadcast waves transmitted from transmission stations of the same network, and pieces of location information relating to the transmission stations by associating the pieces of location information with the transmission frequencies; location acquiring means for acquiring location information relating to location of the broadcast receiver system; initiating means for generating initiating commands to initiate a network follow in accordance with the quality of the received television broadcast waves; and control means responsive to the initiating commands for selecting, from the stored contents in the storing means, a transmission frequency of receivable television broadcast wave that belongs to a broadcast network of a broadcast being currently received and is different from the frequency of the broadcast wave currently being received in accordance with the location information acquired by the location acquiring means, and for setting the selected transmission frequency to the tuner.

The location providing means may be a navigation system.

The control means allows selecting among a transmission frequency corresponding to the same location information as the acquired location information and transmission frequencies corresponding to location information that indicates geographical locations in the vicinity of the geographical location indicated by the acquired location information.

A broadcast receiver according to another embodiment of the present invention is a broadcast receiver having a tuner for receiving television broadcast waves of selected tuning frequencies, comprising: receiving means for receiving digital audio broadcast waves; demodulating means for demodulating the digital audio broadcast waves to obtain a transmitter identification signal for identifying a transmitter that transmits the broadcast waves; storing means for storing, for each television broadcast network, transmission frequencies of television broadcast waves transmitted from transmission stations of the same network, and pieces of information for identifying the transmitters by associating the pieces of information with the transmission frequencies; initiating means for generating initiating commands to initiate a network follow in accordance with the quality of the received television broadcast waves; and control means responsive to the initiating commands for selecting, from the stored contents in the storing means , a transmission frequency of receivable television broadcast wave that belongs to a broadcast network of a broadcast being currently received and is different from the frequency of the broadcast wave currently being received in accordance with the transmitter identification signal, and for setting the selected transmission frequency to the tuner.

The digital audio broadcast waves may be the DAB system broadcast waves.

The control means allows selecting among a transmission frequency corresponding to the transmission frequency corresponding to the transmitter identification signal, and transmission frequencies corresponding to the identifying information for the transmitters geographically in the vicinity of the transmitter.

A broadcast receiver according to still another embodiment of the present invention is a broadcast receiver having a tuner for receiving television broadcast waves of selected tuning frequencies, comprising: receiving means for receiving data multiplexed audio broadcast waves; demodulating means for demodulating the data multiplexed audio broadcast waves to obtain location codes for indicating geographic locations of transmission stations that transmit the broadcast waves; storing means for storing, for each television broadcast network, transmission frequencies of television broadcast waves transmitted from transmission stations of the same network, and location codes corresponding to the transmission stations by associating the location codes with the transmission frequencies; initiating means for generating initiating commands to initiate a network follow in accordance with the quality of the received television broadcast waves; and control means responsive to the initiating commands for selecting, from the stored contents in the storing means , a transmission frequency of a transmission frequency receivable television broadcast wave that belongs to a broadcast network of a broadcast being currently received and is different from the frequency of the broadcast wave currently being received in accordance with the location codes obtained by the demodulating means, and for setting the selected transmission frequency to the tuner.

The data multiplexed audio broadcast waves may be RDS broadcast waves or FM multiplexed broadcast waves.

The control means allows selecting among a transmission frequency corresponding to the location code obtained by the demodulating means, and transmission frequencies corresponding to the location codes that indicate geographical locations in the vicinity of the geographical location indicated by the location code obtained by the demodulating means.

In the foregoing broadcast receiver of each embodiment, the initiating means comprises detecting means for detecting the reception intensity of an electromagnetic field of the television broadcast waves, and generates the initiating commands in the case where the reception intensity of an electromagnetic field falls below a predetermined value.

Furthermore, the control means allows setting, to the tuner, a transmission frequency of television broadcast wave that provides the best reception quality among the selected broadcast waves.

### BRIEF DESCRIPTION OF THE DRAWINGS

Fig.1 is a block diagram showing the schematic configuration of the broadcast receiver system of the first embodiment according to the present invention,
Fig.2 is a conceptual diagram showing TII to be assigned by the DAB system,
Fig.3 is an example of a data map showing the memory formats for frequencies of the DAB signal and a television signal of each TII, which is used in the broadcast receiver system shown in Fig.1,
Fig.4 is a memory map of the broadcast receiver system shown in Fig.1,
Fig.5 is a flowchart showing the processing procedure of the television network follow executed by the controller of the receiver system shown in Fig.1,
Fig.6 is a block diagram showing the schematic configuration of the broadcast receiver system of the second embodiment according to the present invention,
Fig.7 is a memory map of the broadcast receiver system shown in Fig.6,
Fig.8 is a flowchart showing the processing procedure of the television network follow executed by the controller of the receiver system shown in Fig.6,
Fig.9 is a block diagram showing the schematic configuration of the broadcast receiver system of the third embodiment according to the present invention,
Fig.10 is a memory map of the broadcast receiver system shown in Fig.9, and
Fig.11 is a flowchart showing the processing procedure of the television network follow executed by the controller of the receiver system shown in Fig.9.

### DETAILED DESCRIPTION OF THE PREFERRED EMBODIMENTS

The embodiments of the present invention will be explained in detail below with reference to the drawings.

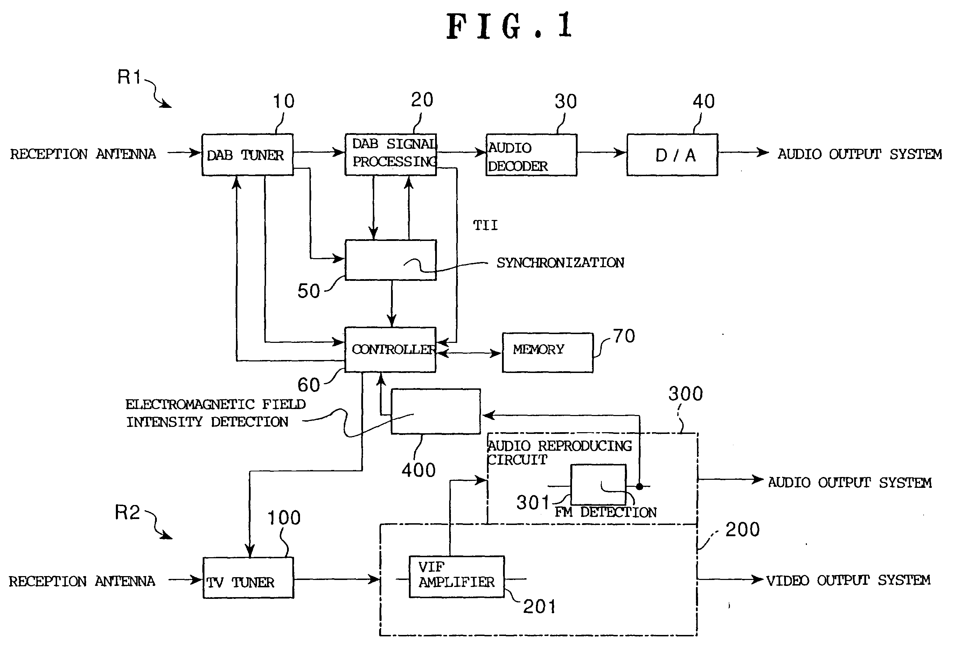

Fig.1 is a block diagram showing the schematic configuration of the broadcast receiver system of the first embodiment according to the present invention.

The receiver is an example of a receiver, to which the present invention is applied, conforming to the digital audio broadcast (hereinafter designated DAB) system pursuant to European Standards (Eureka 147), one of the systems which perform transmission and reception of broadcast waves having data signals, in a predetermined format, and which includes digital audio signals.

Referring to Fig.1, the DAB reception system R1 is provided with a DAB tuner 10 as a front end to which a reception signal captured by a reception antenna is supplied. The DAB tuner 10 tunes for a frequency shown by a frequency determination signal supplied by a controller 60, and selectively receives a DAB signal of the tuning frequency. The DAB signal received by the DAB tuner 10 is supplied to a DAB signal processor 20.

Furthermore, the DAB tuner 10 has a function of generating a so-called S-meter output signal as a signal intensity signal and a null symbol detection signal as a synchronizing signal in accordance with the received DAB signal, supplying the S-meter output signal to the controller 60 and the null symbol detection signal to a synchronizing section 50.

The DAB signal processor 20 performs signal processing such as demodulation processing that is inherent in the DAB system under a predetermined synchronization control, and sends an audio data signal provided by the processing to an audio decoder 30. Synchronizing control performed at the DAB signal processor 20 is governed by the synchronizing section 50. The synchronizing section 50 receives a phase reference symbol detected at the DAB signal processor 20 in addition to the null symbol detection signal from the DAB tuner 10 to generate, in accordance with the phase reference symbol, a control signal required for synchronization at the DAB signal processor 20, supplying a synchronization detection signal to the controller 60 as well.

The audio decoder 30 applies the decoding processing following the DAB system (e.g., including data expansion processing) to the audio data from the DAB signal processor 20, and supplies the resultant digital audio signal to a D/A converter 40. The D/A converter 40 converts the digital to analog audio signal and supplies the analog signal to an audio output system (not shown). The audio output system includes processing for outputting sound corresponding to the analog audio signal.

The DAB signal processor 20 also detects TII (Transmitter Identification Information) which is an additional data signal inherent to the DAB system and supplies it to the controller 60. Using the TII and in cooperation with a memory 70, the controller 60 realizes the television network function which is inherent to the present invention. The TII and the television network function will be described in detail later.

The fundamental configuration of the DAB receiver is disclosed in Japanese Laid-Open Patent Publication No.H9-219654 (1997), Japanese Laid-Open Patent Publication No.H9-312627 (1997), and Japanese Laid-Open Patent Publication No.H9-238089 (1997) which are available for reference.

The hardware configuration of the DAB reception system R1 has been explained in the foregoing. The receiver system of the present invention is provided with, in addition to the reception system R1, a video broadcast reception system R2 for receiving television broadcast in combination with the reception system R1.

The video broadcast reception system R2 is provided with a TV tuner 100, as a front end, to which the reception signal captured by the reception antenna is supplied. The TV tuner 100 tunes for the frequency shown by the frequency determination signal supplied by the controller 60, and selectively receives the television signal of the tuning frequency. The television signal received by the tuner 100 is supplied to a video reproducing circuit 200.

A variety of electronic circuits that are adopted by ordinary television receivers may be adapted to the video reproducing circuit 200. For example, applicable to the video reproducing circuit 200 are a video intermediate frequency (VIF) amplifying circuit for amplifying intermediate frequency signals supplied by the TV tuner 100, a video detecting circuit for demodulating the VIF output into video signals, a video amplifying circuit for amplifying the detected output signals, and circuits for color demodulation and reproduction of the amplified output. The output of the video reproducing circuit 200 is supplied to a video output system (not shown).

The video reproducing circuit 200 provides signals including audio signals and supplies them to the audio reproducing circuit 300. A variety of circuits that are adopted by ordinary television receivers may be applicable to the video reproducing circuit 300. For example, applicable to the video reproducing circuit 300 are an audio intermediate frequency (AIF) detecting circuit for demodulating signals supplied from the VIF amplifying circuit 201 in the video reproducing circuit 200, which is an example of the foregoing, into the audio intermediate frequency signal, an FM detecting circuit for demodulating the AIF output into the audio signal, and an audio amplifying circuit for amplifying the audio signal. The output of an audio reproducing circuit 300 is supplied to an audio output system, which is not shown.

The output audio signal of the FM detecting circuit 301 of the audio reproducing circuit 300, which is an example of the foregoing, is inputted to the electromagnetic-field intensity detecting circuit 400. The electromagnetic-field intensity detecting circuit 400 measures, for example, an S/N ratio of the audio signal as an indication of reception quality of the video broadcast reception system R2, and then supplies a signal to the controller 60 as the electromagnetic-field intensity in accordance with the measurement results. It should be noted that the electromagnetic-field intensity is a signal that represents reception quality relating to the audio systems, however, the signal is considered to represent, indirectly, the reception quality of video systems in the present embodiment and thus is used for initiating the television network follow. It should also be noted, a signal representing the reception quality of video systems may be produced not only by the electromagnetic-field intensity detecting circuit 400, but by other means so as to use the signal to initiate the television network follow. Alternatively, a signal representing the reception quality may be produced in accordance with both video and audio systems. In the present embodiment, the electromagnetic-field intensity detecting circuit 400 performs part of the function of the initiating means for generating commands for initiating television network follow in accordance with the reception quality of television broadcast waves.

Next, the TII that is detected at the aforementioned DAB signal processor 20 will be explained below.

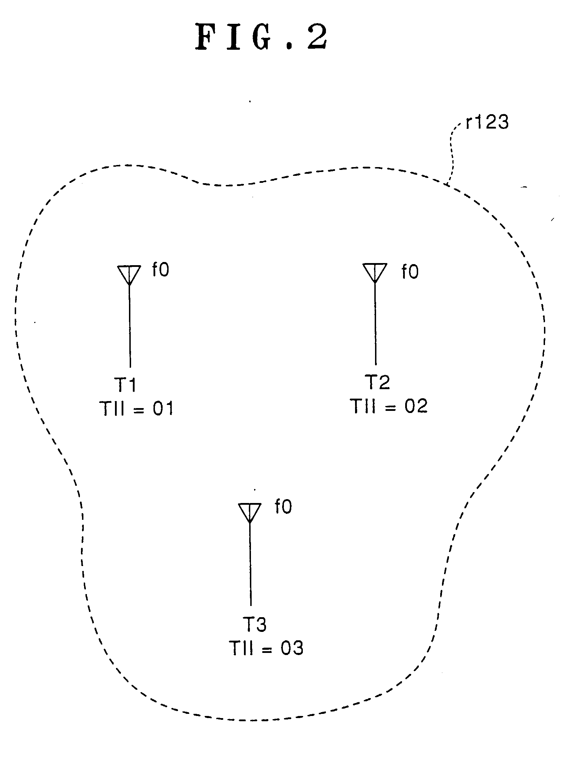

Fig.2 shows a conceptual diagram of TII to be assigned by the DAB system.

The DAB system, adopting a form of single frequency network (SFN), assigns the same transmission frequency (f=f0) to transmitters T1, T2, and T3, which are stationary stations adequately distributed as shown in the figure, in order to secure a wide reception area r123.

In the foregoing, a transmitter is assigned a TII that is inherent to the transmitter, permitting a unique TII to be included individually in the DAB signal to transmit the TII. For example, the TII of transmitter T1 is assigned "01", the TII of transmitter T2 "02", and the TII of transmitter T3 "03". The information of TII may be recognized not only as identification of transmitters but also as information relating to geographic locations, that is, as information relating to latitudes and longitudes that show the locations of transmitters (transmission positions).

The receiver receives TII signals thus assigned and analyzes them, whereby it can be known which transmitter transmitted the DAB signal that is received. This means that the received TII allows receivers to recognize approximate locations thereof. In other words, the receiver can recognize that the location of reception is close to the location of the transmitter corresponding to the TII obtained from the received DAB signal.

Each transmitter can transmit a plurality of DAB signals and television signals of different frequencies. Accordingly, frequencies of TII, and frequencies of DAB signals and television signals have a relation such that one TII is associated with frequencies of a plurality of DAB signals and television signals.

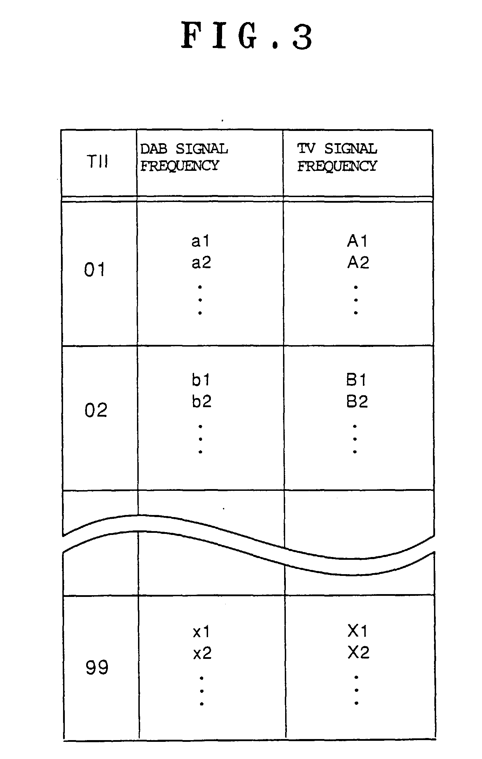

For example, Japanese Laid-Open Patent Publication No.H9-219658 (1997) disclosed a technology for storing a list of frequencies related to the TII into a memory. According to the technology, an embodiment wherein the aforementioned controller 60 controls the tuning control of the DAB tuner 10 as appropriate to store a list of frequencies of DAB signals and television signals associated with each TII into the memory 70. Thus, a list of frequencies shown in Fig.3 is provided.

As shown in Fig.3, frequencies of the DAB signal and frequencies of the television signal are stored for each TII. Accordingly, based on such stored contents as this, a transmitter with TII=01 transmits DAB signals of frequency a1, a2, ... and television signals of frequency A1, A2 .... A transmitter with TII=02 transmits DAB signals of frequency b1, b2, ... and television signals of frequency B1, B2, .... Likewise for another TII, it can be seen from the figure that signals corresponding to the TII are transmitted.

The present embodiment allows associating networks and information relating to frequencies together with TII as information relating to transmission locations to store them in the memory 70, and for using the stored contents for the television network follow.

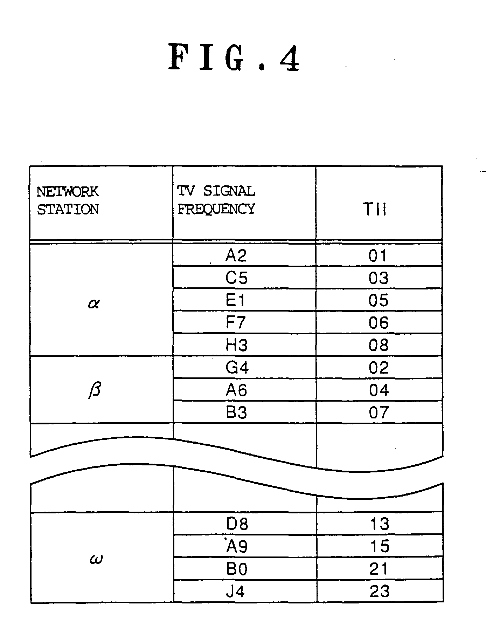

The contents of the memory 70, which are used for television network follow, are shown in Fig.4.

The memory 70 allows storing frequencies of television signals and TII for each network. Accordingly, it can be seen that, for example, the television signal of frequency B3 is used for broadcasting programs of a network station β, and by referring to frequency E1, it can be seen that E1 belongs to a network station α. Conversely, it can also be read immediately from the memory 70 that the frequencies of broadcast waves for providing programs of network station α are A1, C5, E1, F7, and H3; and the frequencies of broadcast waves for providing programs of network station β are G4, A6, and B3.

Furthermore, frequencies of television signals can be read out corresponding to TII. Accordingly, such frequencies as correspond to TII currently being received and such frequencies as correspond to a TII that indicates a transmission location close to that of the TII currently being received can be selectively read out among frequencies corresponding to the related network station. For example, it can be recognized that frequency A2 corresponds to TII=01, and television signals of frequency A2 that provides programs of network stations α are transmitted by a transmitter of TII=01.

Now, the operation of television network follow of the present embodiment, which is performed by means of the memory 70 having the aforementioned contents of memory, will be explained below.

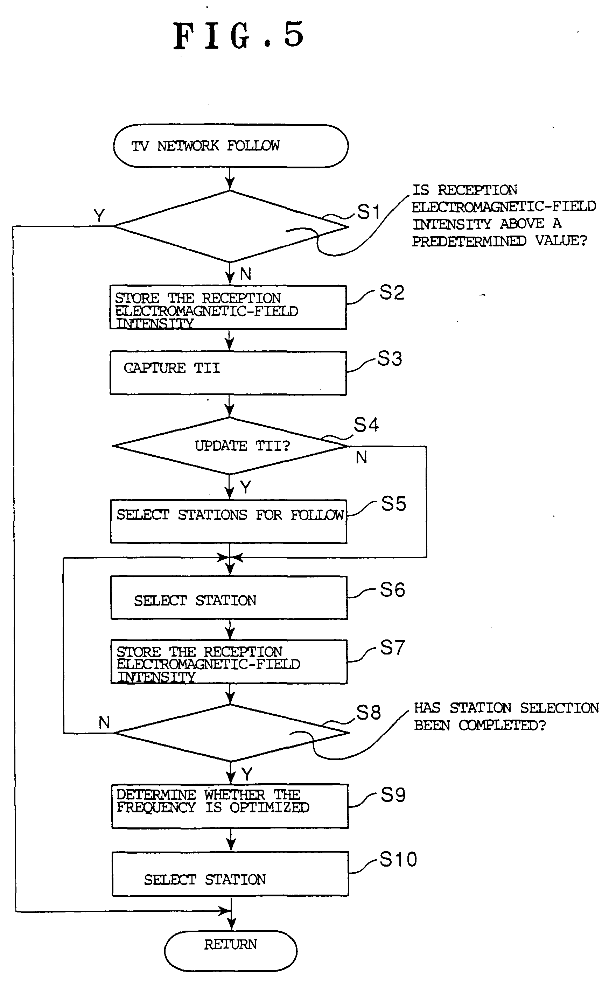

Fig.5 shows the operation flow represented in a form of subroutines that are periodically called as a processing program to be executed by the controller 60 under circumstances where a receiver is receiving a television broadcast of a certain channel.

Referring to Fig.5, at the beginning of this subroutine, the controller 60 first determines whether the reception electromagnetic-field intensity is equal to or greater than a predetermined value (step S1). The reception electromagnetic-field intensity to be determined at this step is based on the value of an output signal of the aforementioned electromagnetic-field intensity detecting circuit 400. When the reception electromagnetic-field intensity has been determined to be equal to or greater than the predetermined value, the controller 60 completes the subroutine in order to maintain the current reception status.

When the reception electromagnetic-field intensity has been determined to be below the predetermined value at step S1, the controller 60 transfers to a control flow for executing the network follow. As the first processing, the controller 60 stores the current reception electromagnetic-field intensity in an internal memory in correspondence with the reception frequency at that time (step S2).

Subsequently, the controller 60 captures TII (step S3). Capturing TII is accompanied by the operation of the DAB reception system. That is, the controller 60 captures TII of the received signal provided by the DAB signal processor 20. This allows the controller 60 to recognize the TII of a transmitter that is transmitting the DAB signal currently being received, and thus the location of transmission.

The controller 60 then determines whether a change has occurred in TII (step S4). This processing is performed by comparison of previously captured TII with currently captured TII.

If a change is found in TII, the controller 60 carries out memory search for selection processing of stations targeted for the follow in accordance with the stored contents of the memory 70 in order to update the information relating to broadcasting stations targeted for the network follow (step S5). If no update is found necessary, the memory search processing is skipped over to station selecting processing at step S6.

To explain the processing at step S5 in more detail, suppose that the frequency of television broadcast waves currently being received is A2, shown in Fig.4. In this case, it can be recognized that the television broadcast waves belong to the network station α according to the contents stored in the memory 70. Therefore, the controller 60 is allowed to read only frequencies C5, E1, F7, and H3, in addition to A2, of the broadcast waves for providing programs of the network station α. All of these frequencies can be selected as targets for station selection processing at step S6 for the network follow.

Furthermore, in the present embodiment, in order to place a limit for station selection processing to only such frequencies as can provide high reception quality or as can be securely received, only those frequencies that meet further conditions are selected from alternative frequencies C5, E1, F7, and H3 in accordance with TII. That is, if a changed TII is, for example, "02", a frequency corresponding to a TII that indicates a transmission location closer to a transmission location that TII=02 indicates (more specifically, a transmission location, from which transmission waves are provided, the transmission waves being considered to be received at the location where the transmission waves from the transmission location that TII=02 indicates can be received) is selected from the contents stored in the memory 70. In this case, the TII meeting these conditions are, for example, "03" and "05", the controller 60 selects frequencies C5 and E1 corresponding to these frequencies to determine them as targeted station information for the network follow.

At step S6, selection of the stations targeted for the network follow is performed in sequence. In the aforementioned example, the controller 60 sets first frequency C5 to the TV tuner 100 as a tuning frequency, and then stores the reception electromagnetic-field intensity after the setting in the internal memory in correspondence with the information relating to frequency C5 (step S7). Subsequently, it is checked whether all station selection operations have been completed for the stations targeted for station selection (step S8). If all operations have not yet been completed, then subsequent selection of a station will be performed again at step S6. In this case, the controller 60 sets frequency E1 to the TV tuner 100 as tuning frequency, and then stores the reception electromagnetic-field intensity after the setting into the internal memory in correspondence with the information relating to frequency E1.

When all station-selection operations have been completed in this way for frequencies targeted for station selection, determination for optimal selection is performed by evaluating the reception electromagnetic-field intensities obtained as a result of station selection (step S9). Stating in detail, processing is performed wherein the greatest value of reception electromagnetic-field intensity of those stored in the aforementioned memory including the information stored at step S2 is determined and the frequency corresponding to the value is selected.

The frequency thus selected is used for final station-selection operation by the network follow at step S10. That is, the controller 60 sets the selected frequency to the tuner 100, and control the tuner 100 to keep the frequency until the subroutine is called again and the reception electromagnetic-field intensity is determined to have decreased at step S1.

As mentioned above, in the first embodiment, the DAB reception system R1 is combined with the TV reception system R2. Information relating to frequencies of television signals and TII^{'}s are stored in advance for each TV network station, and information relating to frequencies of receivable television signals is recognized in accordance with the TII's obtained from the DAB signals. This allows the receiver system to utilize the TII's, which were originally used only for broadcasting audio programs, for realizing network follow of television broadcast in a simple and precise manner.

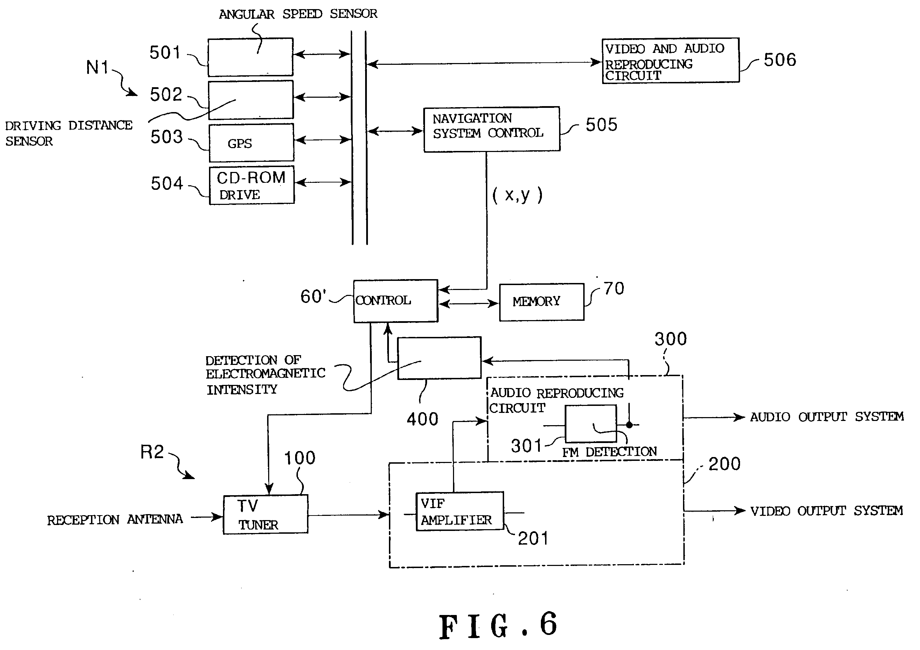

Fig.6 shows a schematic configuration of a broadcast receiver system of the second embodiment according to the present invention.

The broadcast receiver system is an example of the present invention applied to the so-called navigation system.

Referring to Fig.6, navigation system N1 is provided with angle sensor 501, mileage sensor 502, and location information detecting and correcting means in accordance with GPS (Global Positioning System) 503. The location information detecting and correcting means allows providing the geographic location of the system as latitude and longitude (x, y) which is sequentially transferred to the navigation system controller 505 via a bus-line.

The navigation system N1 is also provided with CD-ROM drive 504 for securing information relating to a map necessary for display, and transfers the aforementioned information relating to location and required information in accordance with the commands entered from an operation unit (not shown) to the navigation system controller 505 via a bus-line.

A video and audio reproducing circuit 506 is also connected to the bus-line. The circuit 506 includes circuits for displaying images and for outputting voice according to commands from the system controller 505.

The navigation system controller 505 governs various kinds of control of the whole system. For example, among them are the reading control of the CD-ROM drive 504 and a control of information transfer or reproduction command to the reproducing circuit 506. An operation that relates particularly to the present embodiment is to transfer information relating to location (x, y), provided by the aforementioned location information detecting and correcting means, to a controller 60' in the television reception system R2.

The controller 60' has the same basic function as that of the controller 60 shown in Fig.1 except for the function of control of the DAB reception system R1. In the embodiment, information relating to location (x, y) from the navigation system N1 is to be captured instead of TII of the first embodiment.

As a typical example of a configuration of the navigation system, Japanese Laid-Open Patent Publication No.H9- 297037 (1997) may be referenced.

The video broadcast reception system R2 combined with such a navigation system is the same as that of the first embodiment. However, the contents, used for television network follow, stored in the memory 70 are slightly different.

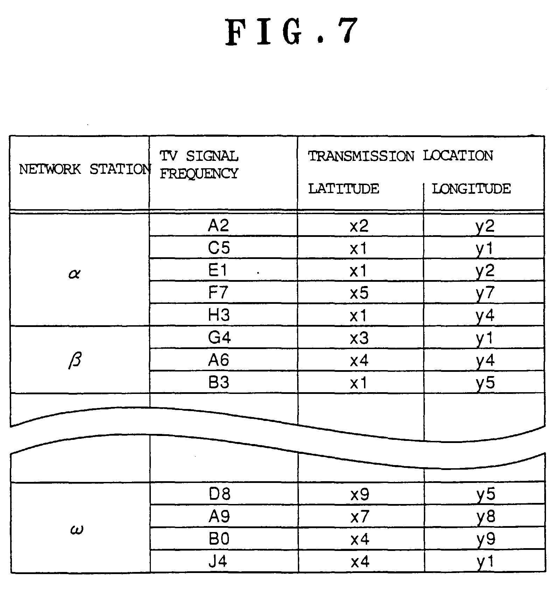

Fig.7 shows the contents stored in the memory 70. In the second embodiment, information relating to latitude and longitude as transmission location information is associated with information relating to network stations and frequencies of television signals and is stored in the memory 70. The contents thus stored are used for television network follow.

Accordingly, frequencies of television signals can be read in correspondence with the respective latitude and longitude information, whereby it is allowed to selectively read, among frequencies corresponding to a network station, such frequencies as are associated with the latitude and longitude information that indicates a transmission location close to the current location. For example, it can be recognized that frequency A2 corresponds to a transmission location (x2, y2), and television signals of frequency A2 that provides programs of the network station α are transmitted from the transmission location (x2, y2).

Next, the operation of television network follow of the second embodiment that is performed using the memory 70 having such storage contents will be explained below.

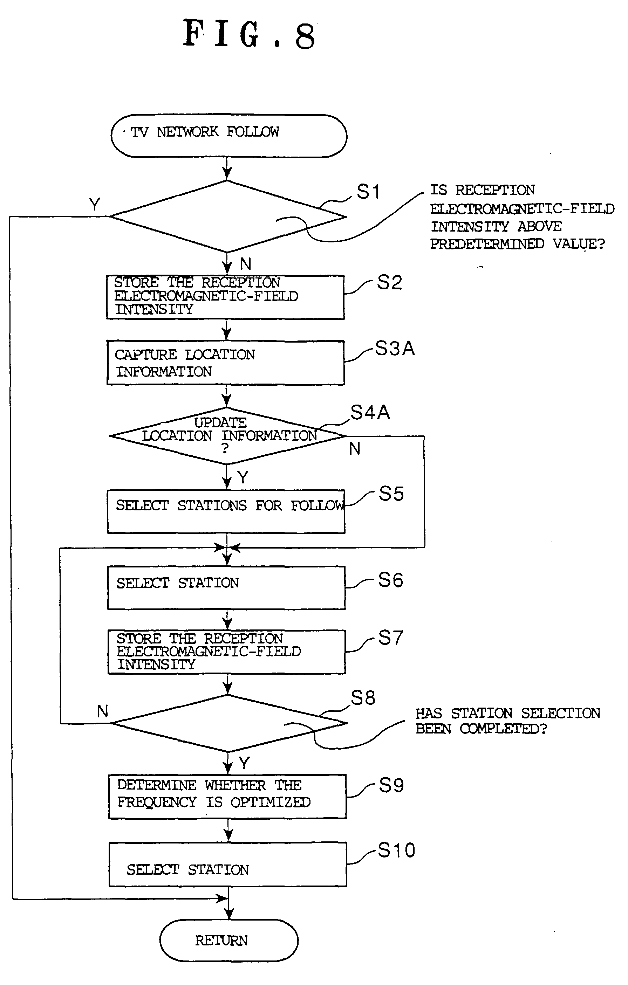

Fig.8 shows the operation flow expressed in a form of subroutine that is a program for processing that the controller 60' executes under circumstances where a receiver is receiving a television program of a certain channel.

Referring to Fig.8, the steps that perform the same processing as those performed in steps of the subroutine shown in Fig.5 are given the same numerals. Therefore, except for step S3A and S4A, the basic operation is similar to that explained when referring to Fig.5, and thus is evident by the explanation in the foregoing.

Steps S3A, S4A, and S5 perform processing which conforms to steps S3A and S4A are processing which is inherent to the second embodiment.

At step S3A, information relating to location (x, y) supplied from the navigation system N1 is captured as processing after step S2. This allows the controller 60 to recognize the current reception location.

Subsequently, the controller 60' determines whether any change has occurred to the information relating to location (step S4A). This processing is carried out by comparing previously captured location information with the currently captured location information.

If a change is found in information relating to location, the controller 60' carries out a memory search for selection processing of stations targeted for the network follow in accordance with the stored contents of the memory 70 in order to update the information relating to broadcasting stations targeted for the network follow (step S5). If no update is found necessary, the memory search processing is skipped over to station selecting processing at step S6.

To explain the processing at step S5 in more detail, suppose that the frequency of television broadcast waves currently being received is A2, shown in Fig.7. In this case, it can be recognized that the television broadcast waves belong to the network station α according to the contents stored in the memory 70. Therefore, the controller 60' is allowed to read frequencies only C5, E1, F7, and H3, in addition to A2, of the broadcast waves for providing programs of the network station α. All of these frequencies can be selected as targets for station selection processing at step S6 for network follow.

Furthermore, in the present embodiment, in order to place a limit for station selection processing to only such frequencies as can provide high reception quality or as can be securely received, only those frequencies that meet further conditions are selected from alternative frequencies C5, E1, F7, and H3 in accordance with the captured location information.

That is, if a changed location information is, for example, equal to (x1, y1), a frequency corresponding to a location closer to the location that (x1, y1) indicates (more specifically, a transmission location, from which transmission waves are provided, the transmission waves being considered to be received at the location that (x1, y1) indicates) is selected from the contents stored in the memory 70. In this case, the transmission locations that meet these conditions are, for example, (x1, y1) and (x1, y2), the controller 60' selects frequencies C5 and E1 corresponding to these frequencies to determine them as targeted station information for the network follow.

As mentioned above, in the second embodiment, the navigation system N1 is combined with the TV reception system R2, information relating to frequencies of television signals and the transmission location are stored in advance for each network station for television broadcast, and information relating to frequencies of receivable television signals are recognized in accordance with location information provided by the navigation system N1. This allows the receiver to utilize location information, which was originally used only for recognizing locations in the navigation system, for realizing network follow of television broadcast in a simple and precise manner.

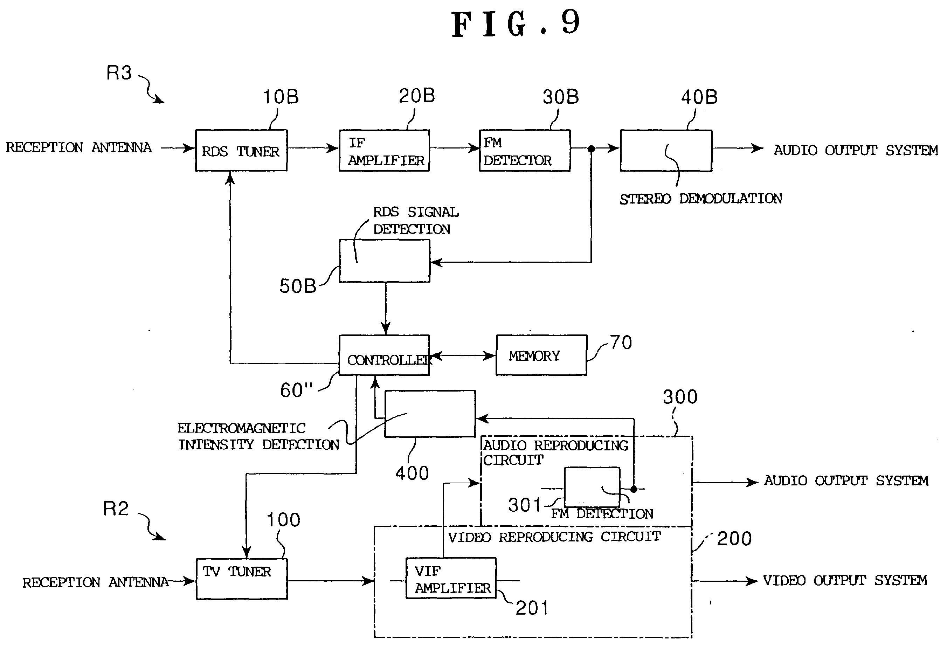

Fig.9 shows an schematic configuration of the broadcast receiver system of the third embodiment according to the present invention.

This broadcast receiver system corresponds to the present invention applied to the aforementioned RDS receiver system.

Referring to Fig.9, RDS reception system R3 is provided, as a front end, with an RDS tuner 10B to which the reception signal captured by the reception antenna is supplied. The RDS tuner 10B tunes for a frequency indicated by a frequency determination signal supplied from a controller 60'', and selectively receives the RDS signal of the tuning frequency to convert it into a signal of intermediate frequency (IF). The IF signal from the RDS tuner 10B is supplied to an IF amplifier 20B to be amplified.

The IF signal amplified by the IF amplifier 20B is demodulated into audio signals by an FM detector 30B. The demodulated output from the FM detector 30B is separated in a stereo demodulating circuit 40B into audio signals for right and left channels in the case of stereo broadcast to be supplied to an audio output system (not shown).

The demodulated output from the FM detector 30B is also supplied to an RDS signal detecting circuit 50B. The RDS signal detecting circuit 50B detects data signals multiplexed in RDS signals from the demodulated output signals to reproduce them. The reproduced data signals are sent to a controller 60''.

The controller 60'' is provided with various kinds of broadcast information from the data signals to perform reception control inherent to the RDS. The controller 60'' also realizes television network functions inherent to the present embodiment, in cooperation with the memory 70, by using PI codes included in the broadcast information and location codes included in the codes. The location code indicates a geographic location of a transmission station that transmits the received broadcast waves, and is used in the present embodiment as information equivalent to the aforementioned TII.

The basic form of the RDS receiver system is disclosed, including the PI codes and location codes provided by the RDS reception system, in Japanese Laid-Open Patent Publication No.H7-58598 (1995), Japanese Laid-Open Patent Publication No.H8-79018 (1996), and Japanese Laid-Open Patent Publication No.H8-79016 (1996), which can be referenced.

The controller 60'' has basically similar functions as the controllers 60 and 60' shown in Fig.1 and Fig.6, respectively, in that the controller 60'' performs control for execution of the network follow. In the present embodiment, the location codes are captured from the RDS reception system R3 for the network follow.

The video broadcast reception system R2 combined with the RDS reception system is equivalent to those of the first and the second embodiments. However, the contents stored in the memory 70, used for television network follow, are slightly different.

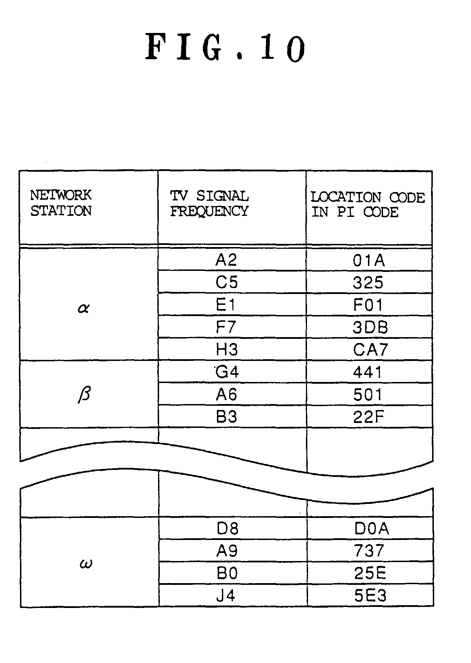

Fig.10 shows the contents stored in the memory 70. In the present embodiment, the location codes as information relating to the transmission locations are associated with the network stations and information relating to the television signal frequencies to be stored in the memory 70. The stored contents are used for the television network follow.

Accordingly, frequencies of the television signals can be read out corresponding to the location codes. Therefore, such frequencies as correspond to a location code that shows a transmission location close to the current location can be selectively read out among frequencies corresponding to the related network station. For example, it can be recognized that frequency A2 corresponds to a transmission location "01A", and television signals of frequency A2 that provide programs of the network stations α are transmitted from a transmission location of "01A".

Now, the operation of television network follow of the third embodiment, which is performed by using the memory 70 having the aforementioned memory contents, will be explained below.

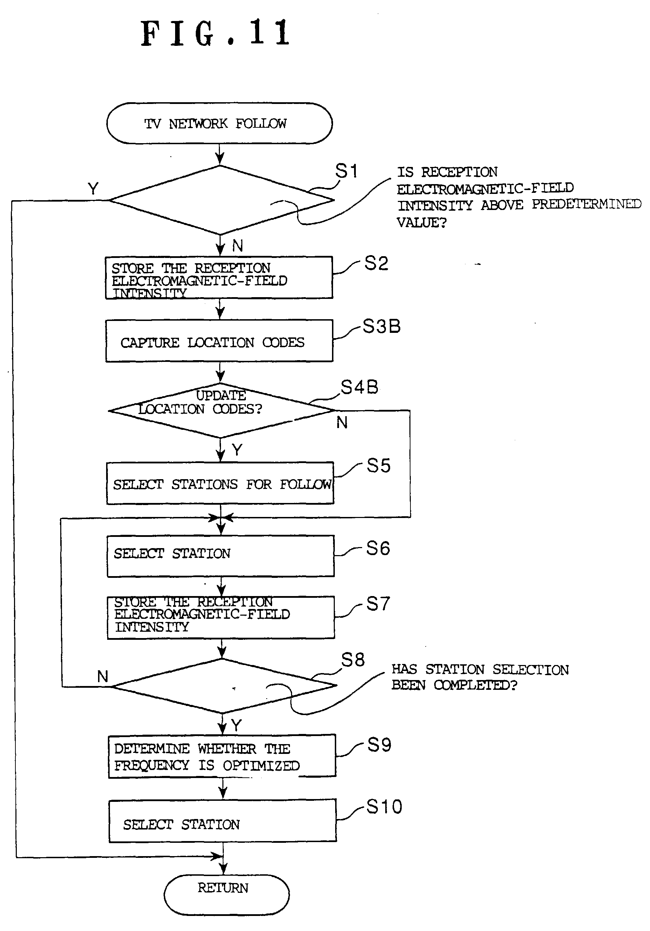

Fig.11 shows the operation flow represented in a form of subroutine that is a periodically operated processing program to be executed by the controller 60'' under circumstances where a receiver is receiving a television broadcast of a certain channel.

Referring to Fig.11, the steps that perform the same processing as those performed at steps of the subroutines shown in Fig.5 and Fig.8 are given the same numerals. Therefore, except for step S3B and S4B, the basic operation is the same as that described in reference to Fig.5 and Fig.8, and thus is evident by the description in the foregoing.

Steps S3B, S4B, and S5 that perform processing which conforms to Steps S3B and S4B are the processing inherent to the third embodiment.

At step S3B, the location codes from the RDS reception system R3 are captured as a processing after step S2. This allows the controller 60" to recognize the current reception location.

Subsequently, the controller 60'' determines whether any change has occurred to the location codes (step S4B). This processing is carried out by comparison of a previously captured location code with the currently captured location code.

If any change is found in location codes, the controller 60'' carries out memory search for selection processing of stations targeted for the network follow in accordance with the stored contents of the memory 70 in order to update the information relating to the broadcasting stations targeted for the network follow (step S5). If no update is found necessary, the memory search processing is skipped over to the station selecting processing at step S6.

To explain the processing at step S5 of the third embodiment in more detail, suppose that the frequency of television broadcast waves currently being received is A2, shown in Fig.10. In this case, it can be recognized that the television broadcast waves belong to the network station α according to the contents stored in the memory 70. Therefore, the controller 60'' is allowed to read frequencies C5, E1, F7, and H3 only, in addition to A2, of the broadcast waves for providing programs of the network station α. All of these frequencies can be selected as targets for station selection processing at step S6 for the network follow.

Furthermore, in the present embodiment, in order to place a limit for station selection processing to such frequencies as can provide high reception quality or as can be securely received, only those frequencies that meet further conditions are selected from alternative frequencies C5, E1, F7, and H3 in accordance with the location codes captured.

That is, if changed location codes are, for example, equal to "325", a frequency corresponding to a location closer to the location that the "325" indicates (more specifically, a transmission location, from which transmission waves are provided, the transmission waves being considered to be received at the location (considered the current location of the receiver) where the transmission waves from the transmission location that "325" indicates can be received) is selected from the contents stored in the memory 70. In this case, the transmission locations that meet these conditions have, for example, location codes "325" and "3DB", the controller 60'' selects frequencies, C5 and F7, corresponding to the location codes to determine them as targeted station information for the network follow.

As mentioned above, in the third embodiment, the RDS reception system R3 is combined with the TV reception system R2, information relating to frequencies of television signals and the transmission location codes are stored in advance for each network station for television broadcast, and information relating to the frequencies of receivable television signals are recognized in accordance with the location codes provided by the RDS reception system R3. This allows the receiver to utilize the location codes, which were originally used only for reception control in the RDS system, for realizing the network follow of television broadcast in a simple and precise manner.

In the foregoing, the examples of the DAB system, navigation system, and RDS system were described to which the present invention is applied. However, the present invention is not limited to these known systems, but is also applicable to another system such as a broadcast receiver for receiving the FM-multiplexed broadcast waves available in Japan.

According to the present invention, a broadcast receiver system can be provided which makes use of the network follow function for television broadcast waves in a simple manner.

## Claims

1. A broadcast receiver system having a tuner for receiving television broadcast waves of selected tuning frequencies, comprising:
storing means for storing, for each television broadcast network, transmission frequencies of television broadcast waves transmitted from transmission stations of the same network, and pieces of location information relating to said transmission stations by associating said pieces of location information with said transmission frequencies;
location acquiring means for acquiring location information relating to location of said broadcast receiver system;
initiating means for generating initiating commands to initiate a network follow in accordance with the quality of the received television broadcast waves; and
control means responsive to said initiating commands for selecting, from the stored contents in said storing means, a transmission frequency of receivable television broadcast wave that belongs to a broadcast network of a broadcast being currently received and is different from the frequency of the broadcast wave currently being received in accordance with said location information acquired by said location acquiring means, and for setting the selected transmission frequency to said tuner.

2. The broadcast receiver system according to Claim 1, wherein said location acquiring means is a navigation system.

3. The broadcast receiver system according to Claims 1 or 2, wherein said control means selects among a transmission frequency corresponding to the same location information as the acquired location information and transmission frequencies corresponding to location information that indicates geographical locations in the vicinity of the geographical location indicated by said acquired location information.

4. A broadcast receiver system having a tuner for receiving television broadcast waves of selected tuning frequencies, comprising:
receiving means for receiving digital audio broadcast waves;
demodulating means for demodulating said digital audio broadcast waves to obtain a transmitter identification signal for identifying a transmitter that transmits the broadcast waves;
storing means for storing, for each television broadcast network, transmission frequencies of television broadcast waves transmitted from transmission stations of the same network, and pieces of information for identifying said transmitters by associating said pieces of information with said transmission frequencies;
initiating means for generating initiating commands to initiate a network follow in accordance with the quality of the received television broadcast waves; and
control means responsive to said initiating commands for selecting, from the stored contents in said storing means , a transmission frequency of receivable television broadcast wave that belongs to a broadcast network of a broadcast being currently received and is different from the frequency of the broadcast wave currently being received in accordance with said transmitter identification signal, and for setting the selected transmission frequency to said tuner.

5. The broadcast receiver system according to Claim 4, wherein said digital audio broadcast waves are DAB system broadcast waves.

6. The broadcast receiver system according to Claims 4 or 5, wherein said control means selects among a transmission frequency corresponding to the transmission frequency corresponding to said transmitter identification signal, and transmission frequencies corresponding to the identifying information for the transmitters geographically in the vicinity of said transmitter.

7. A broadcast receiver system having a tuner for receiving television broadcast waves of selected tuning frequencies, comprising:
receiving means for receiving data multiplexed audio broadcast waves;
demodulating means for demodulating said data multiplexed audio broadcast waves to obtain location codes for indicating geographic locations of transmission stations that transmit the broadcast waves;
storing means for storing, for each television broadcast network, transmission frequencies of television broadcast waves transmitted from transmission stations of the same network, and location codes corresponding to said transmission stations by associating said location codes with said transmission frequencies;
initiating means for generating initiating commands to initiate a network follow in accordance with the quality of the received television broadcast waves; and
control means responsive to said initiating commands for selecting, from the stored contents in said storing means, a transmission frequency of a transmission frequency receivable television broadcast wave that belongs to a broadcast network of a broadcast being currently received and is different from the frequency of the broadcast wave currently being received in accordance with the location codes obtained by said demodulating means, and for setting the selected transmission frequency to said tuner.

8. The broadcast receiver system according to Claim 7, wherein said data multiplexed audio broadcast waves are RDS broadcast waves or FM multiplexed broadcast waves.

9. The broadcast receiver system according to Claims 7 or 8, wherein said control means selects among a transmission frequency corresponding to the location code obtained by said demodulating means, and transmission frequencies corresponding to the location codes that indicate geographical locations in the vicinity of the geographical location indicated by said location code obtained by said demodulating means.

10. The broadcast receiver system according to any one of Claims 1 through 9, wherein said initiating means comprises detecting means for detecting the reception intensity of an electromagnetic field of said television broadcast waves, and generates said initiating commands in the case where said reception intensity of an electromagnetic field falls below a predetermined value.

11. The broadcast receiver system according to any one of Claims 1 through 10, wherein said control means sets, to said tuner, a transmission frequency of television broadcast wave that provides the best reception quality among the selected broadcast waves.
